# EUROPEAN PATENT APPLICATION

(11) **EP 2 403 140 A2**
(43) Date of publication of application: **04.01.2012**
(21) Application number: 11250089.7
(22) Date of filing: 27.01.2011
(51) Int. Cl.: H03H 7/20, H01P 1/18

(54) **Phase shifter**

(30) Priority: 09.06.2010 JP 2010131974
(71) Applicant: Kabushiki Kaisha Toshiba, Minato-ku Tokyo (JP)
(72) Inventor: Tamura, Koichi, Tokyo (JP)
(74) Representative: Granleese, Rhian Jane

(57) **Abstract**

According to one embodiment, a phase shifter (1) includes an input terminal (2); an output terminal (5); a first signal path (3); a second signal path (4); and a switching circuit (16,17) for selectively connecting one of the first signal path (3) and the second signal path (4) to the input terminal (2) and the output terminal (5). The first signal path (3) includes a high-pass filter (8) constituting a main path and a low-pass filter (9) secondarily added in parallel to the high-pass filter (8) and constituting a subsidiary path. The low-pass filter (9) compensates for insertion loss caused by the high-pass filter (8) in a frequency range in which a transmission phase difference is given to an RF signal passing through the high-pass filter (8).

## Description

### FIELD

The embodiments described herein relate to a phase shifter.

### BACKGROUND

An RF phase shifter adds an amount of phase shift to an RF signal such as a microwave signal and a millimeter-wave signal.

A type of phase shifter is known which is configured to switch a signal path between a high-pass filter (HPF) and a low-pass filter (LPF) (see JP, PH03-27807A, for example). Also known is a phase shifter including a high-pass filter in one signal path and a transmission line in the other signal path (see JP, P2008-187661A, for example). In addition, known is a microwave phase shifter including multiple phase-shift units connected together in series (see JP, P2001-094302A, for example).

In a high-pass filter/low-pass filter switching type phase shifter, an amount of phase shift becomes larger around a cutoff frequency at which a transmission characteristic changes in the high-pass filter or in the low-pass filter. However, insertion loss is large around the cutoff frequency. Insertion loss is loss of electric power transmitted from an input terminal to an output terminal.

### BRIEF DESCRIPTION OF THE DRAWINGS

Fig. 1 is a configuration diagram of an RF phase shifter according to a first embodiment;
Fig. 2A is a diagram showing an equivalent circuit of a microwave phase shifter circuit;
Fig. 2B is a diagram showing frequency characteristics of an amount of phase shift;
Figs. 3 is diagram showing a transmission characteristic of a high-pass filter alone;
Figs. 4 is diagram showing a transmission characteristic of a low-pass filter alone;
Fig. 5 is a circuit diagram of a conventional high-pass filter/low-pass filter switching type-phase shifter circuit;
Fig. 6 is diagram showing a transmission characteristic of a microwave phase shifter circuit according to a comparative example;
Fig. 7 is diagram showing a transmission characteristic of the RF phase shifter according to the first embodiment;
Fig. 8 is a diagram showing an example of a two-bit phase shifter circuit in which two RF phase shifters according to the first embodiment are connected together in series;
Fig. 9 is a chart showing combinations of main path filter structures and subsidiary path filter structures;
Figs. 10A to 10D are diagrams showing circuit configurations of RF phase shifters;
Fig. 11A is a configuration diagram of an RF phase shifter according to a third embodiment; and
Fig. 11B is a configuration diagram of an RF phase shifter according to a modification of the third embodiment.

### DETAILED DESCRIPTION

According to one embodiment, a phase shifter includes: an input terminal; an output terminal; a first signal path; a second signal path; and a switching circuit for selectively connecting one of the first signal path and the second signal path to the input terminal and the output terminal. The first signal path includes a first high-pass filter constituting a main path and a first low-pass filter secondarily added in parallel to the first high-pass filter and constituting an subsidiary path. The first low-pass filter compensates for insertion loss caused by the first high-pass filter in a frequency range in which a transmission phase difference is given to an RF signal passing through the first high-pass filter.

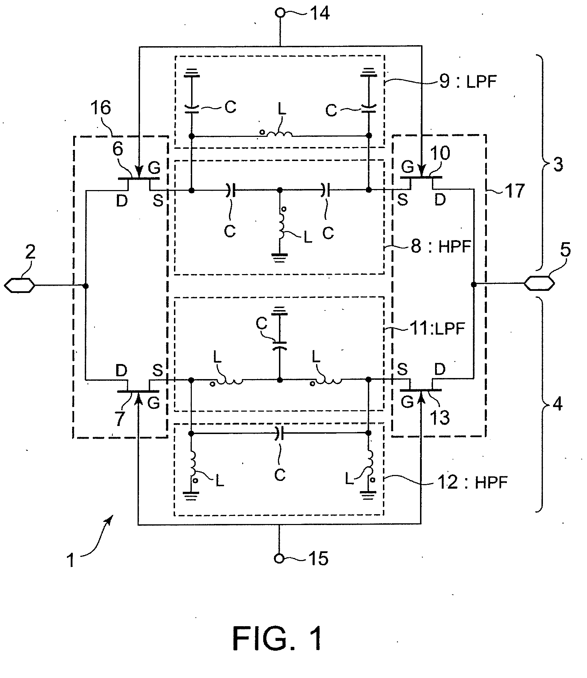

Hereinafter, phase shifters according to embodiments will be described with reference to Fig. 1 to Fig. 11B. Note that the same portions are denoted by the same reference numerals in the drawings, and redundant descriptions are omitted.

### First Embodiment

An RF phase shifter according to a first embodiment is a microwave phase shifter circuit formed in an MMIC (monolithic microwave integrated circuit). Fig. 1 is a configuration diagram of the microwave phase shifter circuit.

A microwave phase shifter circuit 1 includes: a signal path pattern provided on a semi-insulating substrate; FET (field effect transistor) switching elements formed on the substrate; and passive elements such as capacitors (denoted by reference sign C) and inductors (denoted by reference sign L) which are integrated on the substrate, and which serve as lumped-parameter elements for a microwave signal.

The microwave phase shifter circuit 1 includes a first signal path 3 and a second signal path 4 between an input terminal 2 and an output terminal 5. A microwave signal inputted into the input terminal 2 is inputted into the first signal path 3 or the second signal path 4, and is outputted from the output terminal 5. The microwave phase shifter circuit 1 obtains a required amount of phase shift based on the difference between the transmission phase of the first signal path 3 and the transmission phase of the second signal path 4. To select one of the first signal path 3 and the second signal path 4, the microwave phase shifter circuit 1 includes, as switching elements, a first FET 6, a second FET 7, a third FET 10 and a fourth FET 13. The first FET 6 and the second FET 7 are connected to the input terminal 2, whereas the third FET 10 and the fourth FET 13 are connected to the output terminal 5.

The first signal path 3 is arranged between the first FET 6 and the third FET 10, and is connected to the two FETs 6 and 10. The first signal path 3 includes a first high-pass filter 8 and a first low-pass filter 9 secondarily added in parallel to the first high-pass filter 8. The first high-pass filter 8 constitutes a main path, and the first low-pass filter 9 constitutes a subsidiary path.

The second signal path 4 is arranged between the second FET 7 and the fourth FET 13, and is connected to the two FETs 7 and 13. The second signal path 4 includes a second low-pass filter 11 and a second high-pass filter 12 secondarily added in parallel to the second low-pass filter 11. The second low-pass filter 11 constitutes a main path, and the second high-pass filter 12 constitutes a subsidiary path.

The first high-pass filter 8 is a T-type C-L-C (capacitor-inductor-capacitor) circuit. The first low-pass filter 9 is a II-type C-L-C (capacitor-inductor-capacitor) circuit. The second low-pass filter 11 is a T-type L-C-L (inductor-capacitor-inductor) circuit. The second high-pass filter 12 is a II-type L-C-L (inductor-capacitor-inductor) circuit.

The four FETs 6, 7, 10, and 13 are controlled so that their gate bias voltages are set to high or low. The FETs 6, 7, 10, and 13 are turned on when the gate bias voltages are set to high, and the FETs 6, 7, 10, and 13 are turned off when the gate bias voltages are set to low. The first signal path 3 is selected when the FETs 6 and 10 are turned on, and the FETs 7 and 13 are turned off. In contrast, the second signal path 4 is selected when the FETs 6 and 10 are turned off, and the FETs 7 and 13 are turned on. The FETs 6, 7, 10, and 13 constitute a switching circuit. The switching circuit is controlled by control signals fed to control terminals 14 and 15 from outside, and selects the first signal path 3 or the second signal path 4 as the signal path between the input terminal 2 and the output terminal 5.

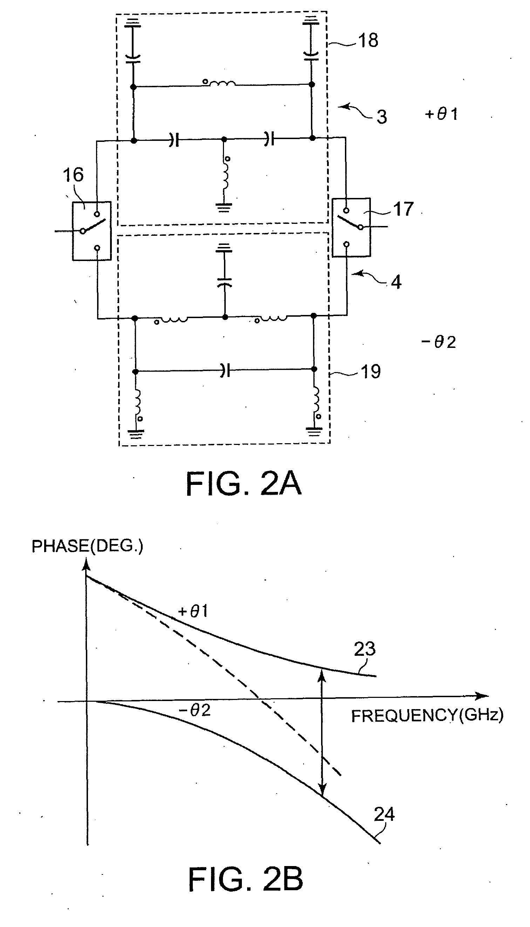

Fig. 2A shows an equivalent circuit of the microwave phase shifter circuit 1. The previously-mentioned reference numerals denote the same elements.

In the first signal path 3, the first high-pass filter 8 and the first low-pass filter 9 constitute a phase shifter circuit portion 18. In the second signal path 4, the second low-pass filter 11 and the second high-pass filter 12 constitute a phase shifter circuit portion 19. +θ1 indicates a transmission phase difference caused by the phase shifter circuit portion 18. -θ2 indicates a transmission phase difference caused by the phase shifter circuit portion 19. One of the phase shifter circuit portion 18 and the phase shifter circuit portion 19 functions as a reference circuit. For example, the phase shifter circuit portion 19 functions as a reference circuit for generating an insertion phase shift of the microwave phase shifter circuit 1. The phase shifter circuit portion 18 functions as a circuit for shifting its phase by a predetermined number of degrees relative to the phase of the phase shifter circuit portion 19.

The FETs 6, 7 constitute an SPDT (single pole double throw) switching circuit 16. The FETs 10, 13 constitute an SPDT switching circuit 17. Note that, as a whole, the switching circuit 16 and the switching circuit 17 constitute a DPDT (double pole double throw) switching circuit.

The switching circuits 16 and 17 switch the signal path serves as a path for a signal inputted to the microwave phase shifter circuit 1 between the first signal path 3 and the second signal path 4 based on a control signal from outside. In other words, the switching circuits 16, 17 select the first signal path 3 or the second signal path 4 as the signal path between the input terminal 2 and the output terminal 5.

The capacitances of the capacitors and the inductances of the inductors constituting the first high-pass filter 8 and the first low-pass filter 9 are determined such that a transmission phase difference caused by the first signal path 3 alone is +θ1. Meanwhile, the capacitances of capacitors and the inductances of inductors constituting the second low-pass filter 11 and the second high-pass filter 12 are determined such that a transmission phase difference caused by the second signal path 4 alone is -θ2.

Fig. 2B is a diagram for explaining frequency characteristics of an amount of phase shift. A curve 23 indicates a frequency characteristic of a transmission phase difference caused by the phase shifter circuit portion 18. A curve 24 indicates a frequency characteristic of a transmission phase difference caused by the phase shifter circuit portion 19. The phase shifter circuit portion 18 causes a +θ1 transmission phase difference and the phase shifter circuit portion 19 causes a -θ2 transmission phase difference, whereby the microwave phase shifter circuit 1 adds a θ1+θ2 phase shift to a signal.

Thus, the microwave phase shifter circuit 1 obtains a required phase shift amount from the difference between the transmission phase in the reference state and the transmission phase in the phase-shift state.

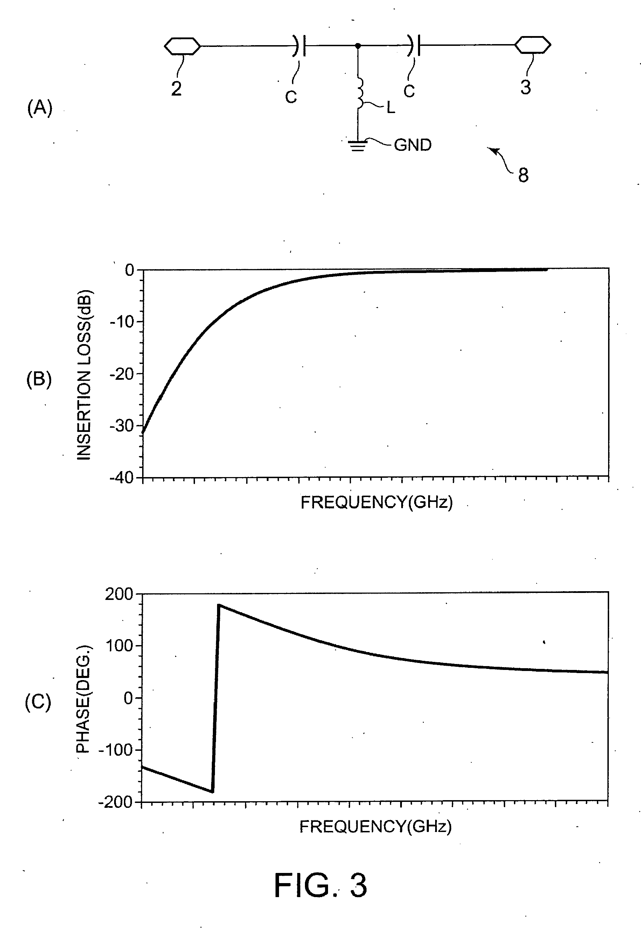

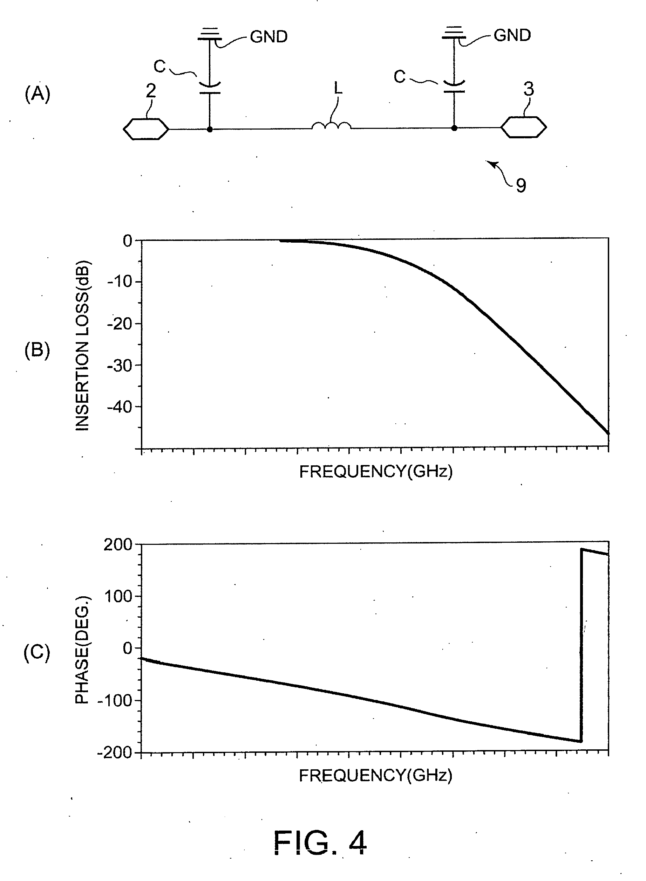

Next, a description will be given of how the microwave phase shifter circuit of this embodiment works to improve the loss characteristic. Firstly, a transmission characteristic of the first high-pass filter 8 alone and a transmission characteristic of the first low-pass filter 9 alone will be described with reference to Figs. 3 and 4. In these drawings, the previously-mentioned reference numerals denote the same portions.

Fig. 3 shows the transmission characteristic of the first high-pass filter 8 alone. The transmission characteristic means a loss characteristic S₂₁ of S-parameters. In Fig. 3, A is an equivalent circuit diagram of the first high-pass filter 8. In Fig. 3, B is a graph showing frequency dependency of insertion loss in the first high-pass filter 8, in which the absolute value of S₂₁ is expressed as magnitude (dB). In Fig. 3, C is a graph showing frequency dependency of transmission phase difference caused by the first high-pass filter 8, in which a phase angle of S₂₁ is expressed as a phase (degrees). The transmission phase difference largely changes around a cutoff frequency at which the characteristic curve of the insertion loss changes its curvature. Transmission loss is large around the cutoff frequency.

Fig. 4 shows the transmission characteristic of the first low-pass filter 9 alone. In Fig. 4, A is an equivalent circuit diagram of the first low-pass filter 9. In Fig. 4, B is a graph showing frequency dependency of insertion loss in the first low-pass filter 9. In Fig. 4, C is a graph showing frequency dependency of transmission phase difference caused by the first low-pass filter 9. The transmission phase difference largely changes around a cutoff frequency at which the characteristic curve changes its curvature. Transmission loss is large around the cutoff frequency.

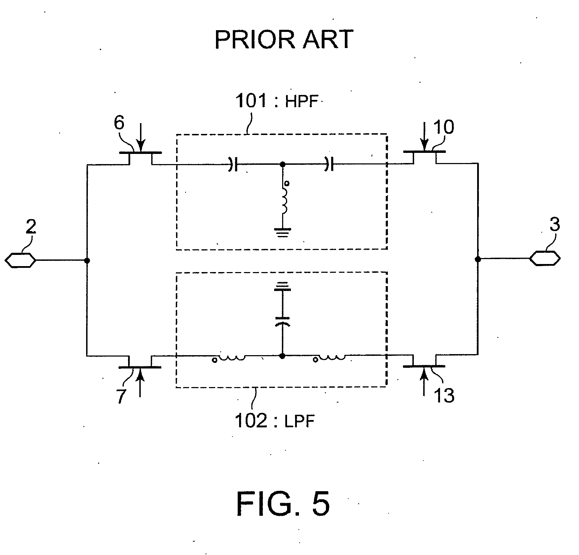

Next, characteristics of a conventional microwave phase shifter circuit will be described. Fig. 5 is a circuit diagram of a conventional high-pass filter/low-pass filter switching type phase shifter circuit. A microwave phase shifter circuit 100 includes: a signal path formed of a first high-pass filter 101 alone and a signal path formed of a first low-pass filter 102 alone. Either the high-pass filter 101 or the low-pass filter 102 is selected by FET switches 6, 7, 10 and 13.

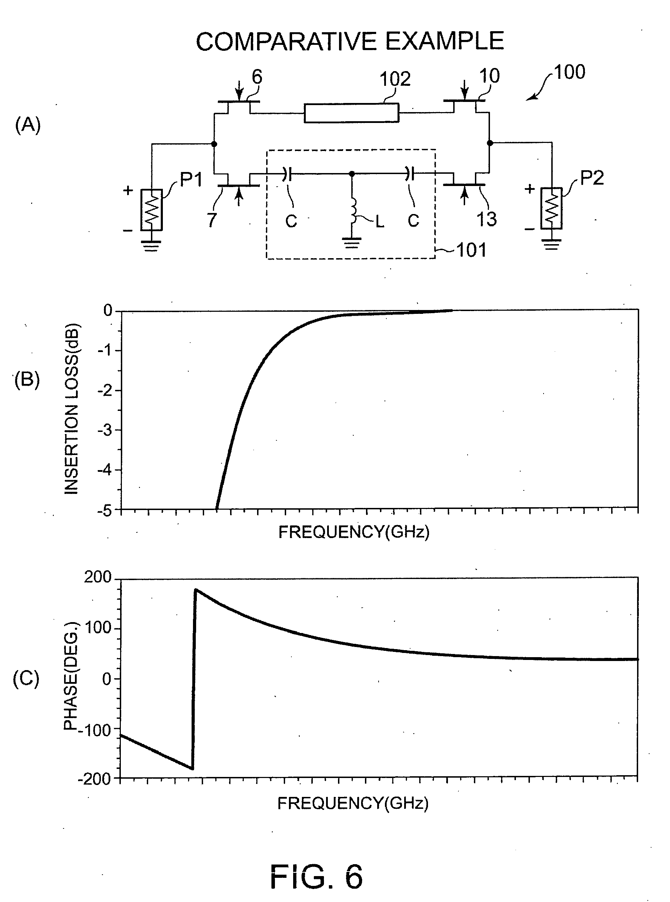

Fig. 6 is a diagram for explaining transmission characteristic of another conventional microwave phase shifter circuit 100. The microwave phase shifter circuit 100 includes: a high-pass filter 101 as one signal path; and a transmission line 102 as the other signal path.

In Fig. 6, A shows an example of a measurement system of the microwave phase shifter circuit 100 in which the high-pass filter 101 is used as the signal path. The high-pass filter 101 is selected by FET switches 6, 7, 10, 13. A terminal P1 corresponds to an input terminal, and a terminal P2 corresponds to an output terminal. In the example shown A of Fig. 6, the high-pass filter 101 is a T-type C-L-C circuit, and the microwave phase shifter circuit 100 shifts a phase by 90 degrees.

In Fig. 6, B is a graph showing frequency dependency of insertion loss in the high-pass filter 101. In Fig. 6, C is a graph showing frequency dependency of transmission phase difference caused by the high-pass filter 101.

Phase difference of the high-pass filter 101 changes largely around the cutoff frequency. That is, insertion loss is large around a frequency at which the phase difference changes largely.

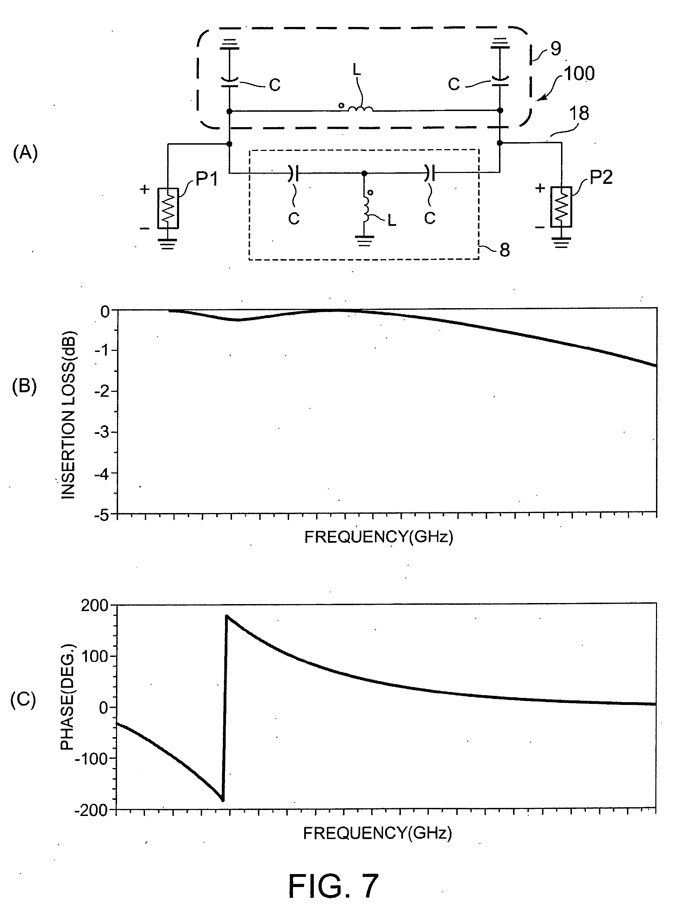

Next, a transmission characteristic of the circuit including the first high-pass filter 8 and the first low-pass filter 9 secondarily added to the first high-pass filter 8 will be described with reference to Fig. 7. This circuit is the phase shifter circuit portion 18 of the first signal path 3 of the microwave phase shifter circuit 1. Accordingly, in Fig. 7, A shows an equivalent circuit of the microwave phase shifter circuit 1 in which the first signal path 3 is selected. The first signal path 3 includes; the first high-pass filter 8 having a T-type C-L-C circuit; and the first low-pass filter 9 having a II-type C-L-C circuit. The first signal path 3 causes a +θ1 transmission phase difference. The element constants of the C-L-C circuit of the first high-pass filter 8 are the same as the element constants of the C-L-C circuit of the high-pass filter 101 shown in A in Fig. 6.

According to this embodiment, it is possible to perform compensation of transmission loss in the first high-pass filter 8 and phase adjustment in a high-frequency band, by adding the first low-pass filter 9 having the II-type C-L-C circuit with a filter structure in parallel to the first high-pass filter 8 having the T-type C-L-C circuit.

In Fig. 7, B is a graph showing frequency dependency of insertion loss in the first signal path 3. In Fig. 7, C is a graph showing frequency dependency of transmission phase difference caused by the first signal path 3.

The microwave phase shifter circuit 100 of Fig. 6 changes the transmission phase difference largely around the cutoff frequency. Meanwhile, the phase shifter circuit portion 18 of the embodiment shown in Fig. 7 improved the loss at the frequency at which the transmission phase difference changes largely. The insertion loss in the microwave phase shifter circuit 1 is smaller than the insertion loss in the microwave phase shifter circuit 100.

In the insertion loss characteristic, insertion loss in a frequency range in which a transmission phase difference is given to a microwave signal by the first signal path 3 is improved by the circuit including the first high-pass filter 8 and the first low-pass filter 9 secondarily added to the first high-pass filter 8. While keeping the high-pass filter/low-pass filter switching type structure, the microwave phase shifter circuit 1 according to this embodiment includes additional the inductor and the capacitors. Thus, the microwave phase shifter circuit 1 prevents increase in insertion loss outside the transmission ranges of the filters, and can improve the transmission characteristic.

The frequency band in which the high-pass filter 8 alone causes a large phase change is a band in which insertion loss is large. In this regard, the circuit including the first high-pass filter 8 and the first low-pass filter 9 secondarily added to the first high-pass filter 8 largely improves the loss at the frequency at which the transmission phase difference changes largely, as shown in B in Fig. 7.

The element constants of the II-type C-L-C circuit of the first low-pass filter 9 are determined such that: the frequency band in which the insertion loss of the first high-pass filter 8 is small and the frequency band in which the insertion loss of the first low-pass filter 9 is small may overlap each other; and a desired transmission phase difference can be obtained. With this configuration, the circuit shown in A in Fig. 7 is capable of compensating for deterioration in the insertion loss while obtaining a required transmission phase difference. In other words, the circuit shown in A in Fig. 7 is capable of reducing the insertion loss while obtaining the amount of transmission phase difference (see C in Fig. 7) which is equal to the amount of transmission phase difference caused before addition of the first low-pass filter 9 (see C in Fig. 6).

Hereinabove, a description has been given of the circuit including the high-pass filter and the low-pass filter secondarily connected in parallel to the high-pass filter. However, the circuit including the low-pass filter and the high-pass filter secondarily connected in parallel to the low-pass filter can similarly reduce the insertion loss while obtaining a certain transmission phase difference. That is, the phase shifter circuit portion 19 of the second signal path can also reduce the insertion loss.

In the second signal path 4, the element constants of the 11-type L-C-L circuit of the second high-pass filter 12 are set, such that: the transmission characteristic of the second low-pass filter 11 constituting the main path and the transmission characteristic of the second high-pass filter 12 constituting the subsidiary path may overlap each other; the insertion loss of the second signal path 4 can be reduced; and a desired transmission phase difference can be obtained.

It is possible to perform compensation of transmission loss in the second low-pass filter 11 and phase adjustment in a high-frequency band by adding the second high-pass filter 12 having the II-type L-C-L circuit with a filter structure in parallel to the second low-pass filter 11 having the T-type L-C-L circuit.

Thus, the RF phase shifter according to this embodiment is capable of reducing the insertion loss by reducing the insertion loss outside the transmission ranges of the filters.

In the conventional high-pass and low-pass filters using the T-type or II-type circuit including inductors (L) and capacitors (C), the insertion loss is large outside the transmission ranges of the filters. This results into deterioration in the characteristic of the phase shifter. According to this embodiment, additional inductors and capacitors are added while keeping the high-pass filter/low-pass filter switching type structure. With this configuration, the RF phase shifter can reduce the insertion loss outside the transmission ranges of the filters, and thus improves the insertion characteristic.

The phase shifter circuit portion 19 is operated as the reference circuit in the above description. Instead, however, the phase shifter circuit portion 18 may be operated as the reference circuit instead.

### Second Embodiment

Next, an embodiment of an RF phase shifter including two microwave phase shifter circuits connected together in series will be described.

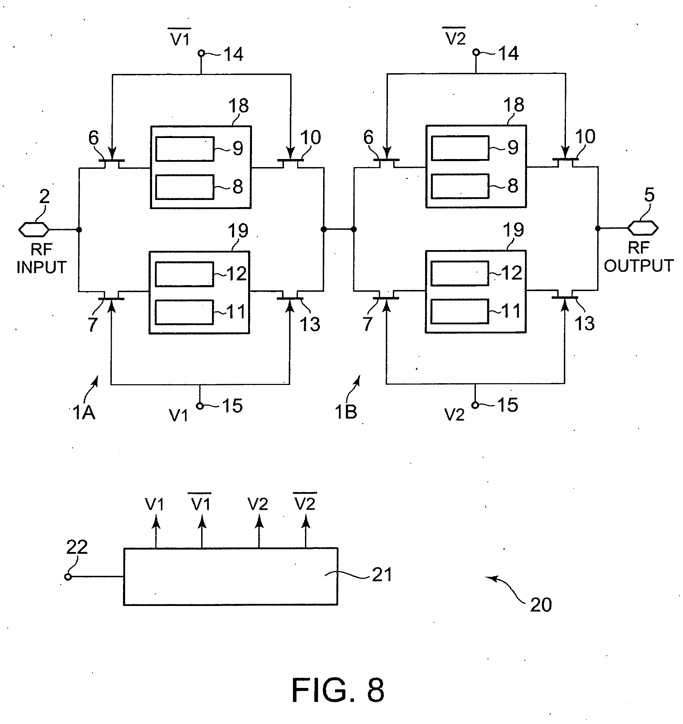

Fig. 8 shows a two-bit phase shifter circuit which includes two microwave phase shifter circuits connected together in series. A two-bit phase shifter 20 includes a first microwave phase shifter circuit 1A, a second microwave phase shifter circuit 1B, and a drive circuit 21 configured to control the amount of phase shift produced by each of the microwave phase shifter circuits 1A, 1B. These circuits are formed on a substrate including a microstrip line. A microwave signal inputted to an input terminal 2 is inputted into the first microwave phase shifter circuit 1A; an output signal from the first microwave phase shifter circuit 1A is inputted into the second microwave phase shifter circuit 1B; and an output signal from the second microwave phase shifter circuit 1B is outputted from an output terminal 5.

For example, the amount of phase shift caused by the first microwave phase shifter circuit 1A is 90 degrees, and the amount of phase shift caused by the second microwave phase shifter circuit 1B is 180 degrees.

Each of the microwave phase shifter circuit 1A, 1B includes a phase shifter circuit portion 18 and a phase shifter circuit portion 19. Like in the case of the first embodiment, each phase shifter circuit portion 18 includes a first high-pass filter 8 and a first low-pass filter 9 secondarily added in parallel to the first high-pass filter 8. The first high-pass filter 8 constitutes a main path, and the first low-pass filter 9 constitutes an subsidiary path. In addition, like in the case of the first embodiment, each phase shifter circuit portion 19 includes a second low-pass filter 11 and a second high-pass filter 12 secondarily added in parallel to the second low-pass filter 11. The second low-pass filter 11 constitutes a main path, and the second high-pass filter 9 constitutes an subsidiary path.

One of the phase shifter circuit portion 18 and the phase shifter circuit portion 19 of the first microwave phase shifter circuit 1A, for example, the phase shifter circuit portion 19, functions as a reference circuit for generating an insertion phase of the first microwave phase shifter circuit 1A. The phase shifter circuit portion 18 of the first microwave phase shifter circuit 1 functions as a circuit for shifting its phase by 90 degrees relative to the phase of the phase shifter circuit portion 19.

The phase shifter circuit portion 19 of the second microwave phase shifter circuit 1B functions as a reference circuit for generating an insertion phase of the second microwave phase shifter circuit 1B. The phase shifter circuit portion 18 of the second microwave phase shifter circuit 1B functions as a circuit for shifting its phase by 180 degrees relative to the phase of the phase shifter circuit portion 19.

A phase shift amount-control signal is inputted from a terminal 22 into the drive circuit 21. The drive circuit 21 performs control according to an instruction indicated by the phase amount-control signal, such that gate bias voltages of four FETs 6, 7, 10, 13 of the first microwave phase shifter circuit 1A and gate bias voltages of four FETs 6, 7, 10, 13 of the second microwave phase shifter circuit 1B are set high or low.

In the phase shifter 20, the amount of phase shift is controlled by a two-bit control signal inputted into the drive circuit 21. Upon input of the two-bit control signal into the drive circuit 21, the drive circuit 21 supplies a high or low gate bias voltage to control terminals 14, 15 of the first microwave phase shifter circuit 1A and control terminals 14, 15 of the second microwave phase shifter circuit 1B. This controls the FETs 6, 7, 10, 13 of each of the microwave phase shifter circuits 1A, 1B to select the phase shifter circuit portion 18 or the phase shifter circuit portion 19, and thereby determine the amount of phase shift to be produced by each of the microwave phase shifter circuits 1A, 1B. Hence, the amount of phase shift to be produced by the phase shifter 20 is determined.

When the phase shifter 20 shifts a phase by 0 degree, control signal "00" is inputted into the drive circuit 21. The "0" at the beginning indicates that the control signal for the first microwave phase shifter circuit 1A is "0." The "0" at the end indicates that the control signal for the second microwave phase shifter circuit 1B is "0." In this case, the drive circuit 21 turns off the FETs 6, 10, and turns on the FETs 7, 13 in the first microwave phase shifter circuit 1A. Meanwhile, the drive circuit 21 turns off the FETs 6, 10, and turns on the FETs 7, 13 in the second microwave phase shifter circuit 1B. Hence, a microwave signal inputted to the input terminal 2 passes through the phase shifter circuit portion 19 of the first microwave phase shifter circuit 1A and the phase shifter circuit portion 19 of the second microwave phase shifter circuit 1B, and is outputted from the output terminal 5.

When the phase shifter 20 shifts a phase by 90 degrees, control signal "10" is inputted into the drive circuit 21. The "1" at the beginning indicates that the control signal for the first microwave phase shifter circuit 1A is "1." The "0" at the end indicates that the control signal for the second microwave phase shifter circuit 1B is "0." In this case, the drive circuit 21 turns on the FETs 6, 10, and turns off the FETs 7, 13 in the first microwave phase shifter circuit 1A. Meanwhile, the drive circuit 21 turns off the FETs 6, 10, and turns on the FETs 7, 13 in the second microwave phase shifter circuit 1B. Hence, a microwave signal inputted to the input terminal 2 passes through the phase shifter circuit portion 18 of the first microwave phase shifter circuit 1A and the phase shifter circuit portion 19 of the second microwave phase shifter circuit 1B, and is outputted from the output terminal 5. The phase of the output signal is shifted by 90 degrees relative to the phase of the output signal in a case where the control signal is "00."

When the phase shifter 20 shifts a phase by 180 degrees, control signal "01" is inputted into the drive circuit 21. In this case, the drive circuit 21 turns off the FETs 6, 10, and turns on the FETs 7, 13 in the first microwave phase shifter circuit 1A. Meanwhile, the drive circuit 21 turns on the FETs 6, 10, and turns off the FETs 7, 13 in the second microwave phase shifter circuit 1B. Hence, a microwave signal inputted to the input terminal 2 passes through the phase shifter circuit portion 19 of the first microwave phase shifter circuit 1A and the phase shifter circuit portion 18 of the second microwave phase shifter circuit 1B, and is outputted from the output terminal 5. The phase of the output signal is shifted by 180 degrees relative to the phase of the output signal in a case where the control signal is "00." That is, the two-bit phase shifter 20 adds a phase shift amount of 180 degrees.

When the phase shifter 20 shifts a phase by 270 degrees, control signal "11" is inputted into the drive circuit 21. A microwave signal inputted to the input terminal 2 passes through the phase shifter circuit portion 18 of the first microwave phase shifter circuit 1A and the phase shifter circuit portion 18 of the second microwave phase shifter circuit 1B, and is outputted from the output terminal 5. The phase of the output signal is shifted by 270 degrees relative to the phase of the output signal in a case where the control signal is "00."

Thus, the phase shifter 20 generates required amount of phase shift.

### Modifications of First Embodiment

In the first embodiment, the first high-pass filter 8 constituting the main path in the first signal path 3 is a T-type C-L-C circuit, and the second low-pass filter 11 constituting the main path in the second signal path 4 is a T-type L-C-L circuit. In other words, the circuit structure of the main path through which a high-frequency microwave passes and the circuit structure of a main path through which a low-frequency microwave passes are T-T. However, in an RF phase shifter, the circuit structures of the main path in the first signal path 3 through which a high-frequency microwave passes and the main path in the second signal path 4 through which a low-frequency microwave passes may be T-Π, Π-T or Π-Π.

In the first embodiment, the first high-pass filter 8 and the second low-pass filter 11 are both RF main paths, and the first low-pass filter 9 and the second high-pass filter 12 are both RF subsidiary paths. In other words, in the first embodiment, the first signal path 3 includes a T-type RF main path and a Π-type RF subsidiary path, whereas the second signal path 4 includes a T-type RF main path and a Π-type RF subsidiary path.

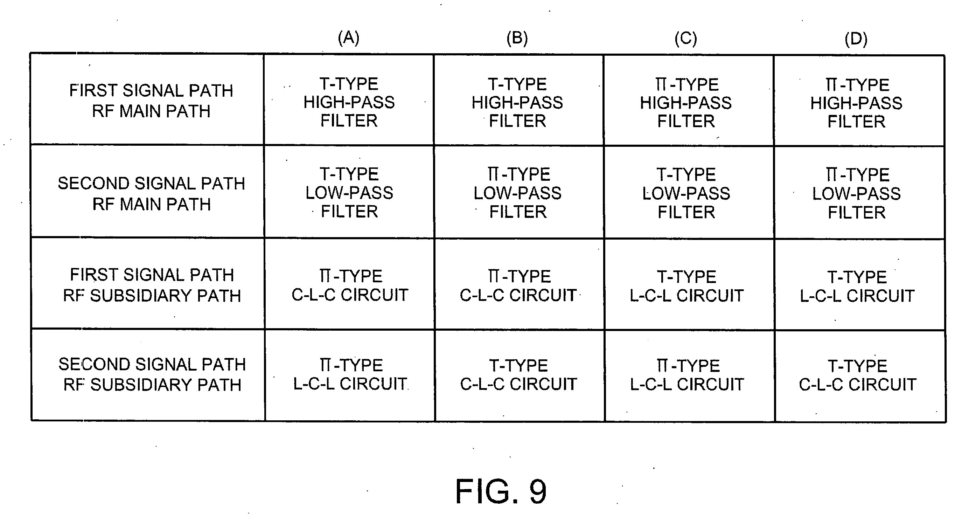

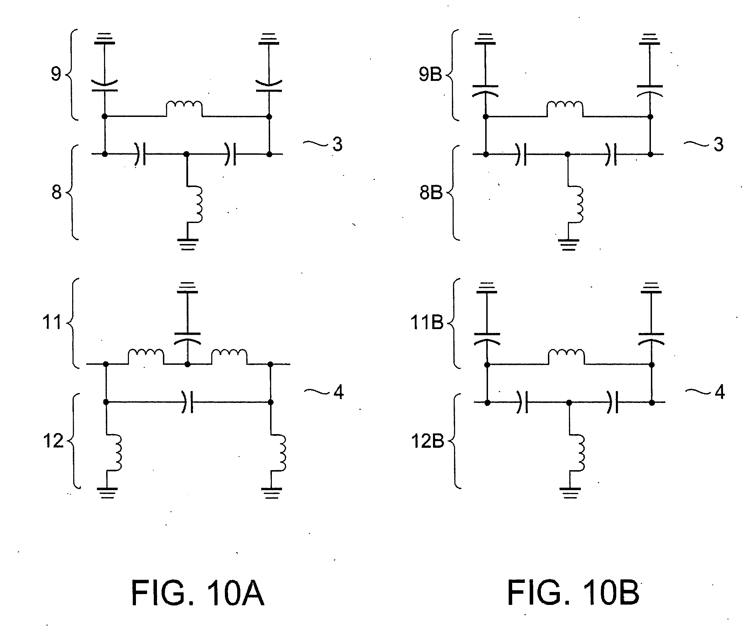

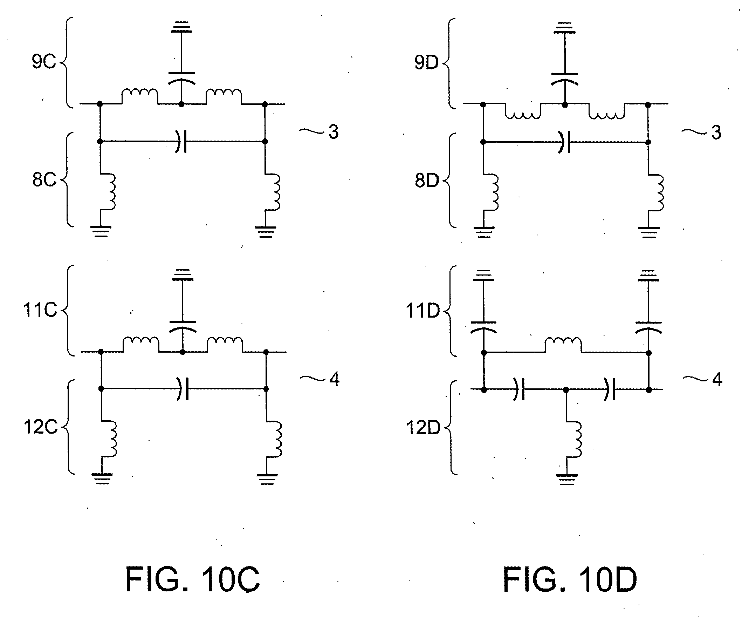

Fig. 9 shows combinations of filter structures of the RF main path of the first signal path 3, the RF main path of the second signal path 4, the RF subsidiary path of the first signal path 3 and the RF subsidiary path of the second signal path 4. These combinations resulted in phase shifters of excellent characteristics. Column A shows a combination of the filter structures in the above-mentioned first example. Columns B, C, D show combinations of filter structures of RF phase shifters according to modifications. Fig. 10A shows a circuit configuration of an RF phase shifter having the filter structure shown in column A of Fig. 9. Fig. 10B shows a circuit configuration of an RF phase shifter having the filter structure shown in column B of Fig. 9. Fig. 10C shows a circuit configuration of an RF phase shifter having the filter structure shown in column C of Fig. 9. Fig. 10D shows a circuit configuration of an RF phase shifter having the filter structure shown in column D of Fig. 9.

As shown in column B of Fig. 9 and Fig. 10B, in a first modification, the first signal path 3 includes a T-type high-pass filter as a main path 8B and a Π-type C-L-C circuit as a subsidiary path 9B. The second signal path 4 includes a Π-type low-pass filter as a main path 11B and a T-type C-L-C circuit as a subsidiary path 12B.

As shown in column C of Fig. 9 and Fig. 10C, in a second modification, the first signal path 3 includes a Π--type high-pass filter as a main path 8C and a T-type L-C-L circuit as a subsidiary path 9C. The second signal path 4 includes a T-type low-pass filter as a main path 11C and a Π-type L-C-L circuit as a subsidiary path 12C.

As shown in column D of Fig. 9 and Fig. 10D, in a third modification, the first signal path 3 includes a Π-type high-pass filter as a main path 8D and a T-type L-C-L circuit as a subsidiary path 9D. The second signal path 4 includes a Π-type low-pass filter as a main path 11C and a T-type C-L-C circuit as a subsidiary path 12D.

In each modification, element constants of the C-L-C circuit and the L-C-L circuit of the RF subsidiary paths are determined such that insertion loss in a transmission characteristic may be reduced, which transmission characteristic is obtained by combining together a transmission characteristic of an RF main path and a transmission characteristic of an RF subsidiary path.

The microwave phase shifters can be implemented by use of the RF phase shifters of the respective modifications, like the RF phase shifter of the first embodiment, by efficiently using the arrangement of circuit elements, for example, on the MMIC.

### Third Embodiment

In the RF phase shifters of the aforementioned embodiments and modifications, each of the first signal path 3 and the second signal path 4 includes filters. However, an RF phase shifter may be configured such that only one of the first signal path 3 and the second signal path 4 includes filters.

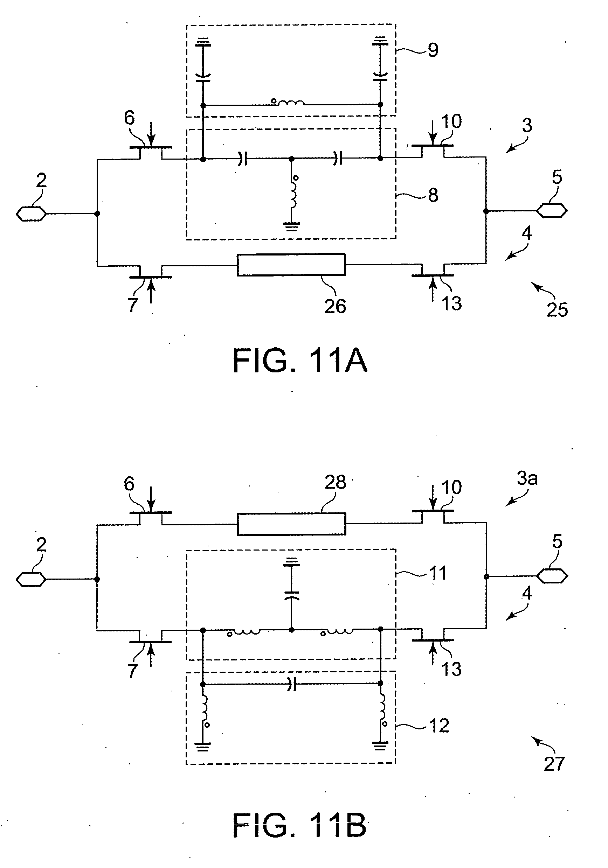

Fig. 11A shows a configuration diagram of an RF phase shifter according to a third embodiment. The previously-mentioned reference numerals denote the same elements. A microwave phase shifter 25 includes a microstrip line 26 serving as a reference circuit in a second signal path 4a. A first signal path 3 includes a T-type high-pass filter and a II-type C-L-C circuit secondarily added thereto. The T-type high-pass filter constitutes a main path, and the Π-type C-L-C circuit constitutes an subsidiary path.

Like in the case of the second embodiment shown in Fig. 8, a 2-bit phase shifter circuit is made by cascade-connecting two microwave phase shifters 25 together. Since the amount of phase shift to be produced by the RF phase shifter 25 according to this embodiment is smaller, the RF phase shifter 25 may be used as a subordinate bit phase shifter circuit having a small amount of phase shift in a multibit microwave phase shifter. The RF phase shifter 25 according to this embodiment may be used as a microwave phase shifter circuit for producing an amount of phase shift which is 22.5 degrees or 11.25 degrees, for example. In addition, since one signal path is formed with a microstrip line, the microwave phase shifter 25 can be implemented with less circuit components.

Fig. 11B shows a configuration diagram of an RF phase shifter according to a modification of this embodiment. The previously-mentioned reference numerals denote the same elements. A microwave phase shifter 27 includes a microstrip line 28 serving as a reference circuit in a first signal path 3a. A second signal path 4 includes a T-type low-pass filter and a II-type L-C-L circuit secondarily added thereto. The T-type low-pass filter constitutes a main path, and the Π-type L-C-L circuit constitutes an subsidiary path. The microwave phase shifter circuit 27 may be used as a phase shifter for producing a small amount of phase.

As has been described, RF phase shifters of small insertion loss can be obtained according to the embodiments and the modifications.

The II-type C-L-C circuit, the II-type L-C-L circuit, the T-type C-L-C circuit or the T-type L-C-L circuit secondarily added to the RF phase shifters according to the embodiments and the modifications may include a resistor, another inductor or another capacitor.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A phase shifter comprising:
an input terminal;
an output terminal;
a first signal path;
a second signal path; and
a switching circuit for selectively connecting one of the first signal path and the second signal path to the input terminal and the output terminal, wherein
the first signal path includes
a first high-pass filter constituting a main path and
a first low-pass filter secondarily added in parallel to the first high-pass filter and constituting an subsidiary path, and
the first low-pass filter compensates for insertion loss caused by the first high-pass filter in a frequency range in which a transmission phase difference is given to an RF signal passing through the first high-pass filter.

2. The phase shifter according to claim 1, wherein the second signal path includes a second low-pass filter.

3. The phase shifter according to claim 1, wherein the second signal path includes a second low-pass filter constituting a main path, and a second high-pass filter secondarily added in parallel to the second low-pass filter and constituting an subsidiary path.

4. The phase shifter according to claim 1, wherein the first high-pass filter is a T-type C-L-C (capacitor-inductor-capacitor) circuit, and the first low-pass filter is a Π-type C-L-C (capacitor-inductor-capacitor) circuit.

5. The phase shifter according to claim 1, wherein the first high-pass filter is a Π-type L-C-L (inductor-capacitor-inductor) circuit, and the first low-pass filter is a T-type L-C-L (inductor-capacitor-inductor) circuit.

6. The phase shifter according to claim 3, wherein the second low-pass filter is a Π-type C-L-C circuit, and the second high-pass filter is a T-type C-L-C circuit.

7. The phase shifter according to claim 3, wherein the second low-pass filter is a T-type C-L-C circuit, and the second high-pass filter is a Π-type C-L-C circuit.

8. The phase shifter according to claim 1, wherein the second signal path is a microstrip line.

9. The phase shifter according to claim 1, wherein the switching circuit constitutes a DPDT (double pole double throw) switch.
